## Europäisches Patentamt

## European Patent Office

## Office européen des brevets

(11) Numéro de publication: **0 112 428**
**B1**

(12) # FASCICULE DE BREVET EUROPÉEN

(45) Date de publication du fascicule du brevet:
12.08.87

(51) Int. Cl.⁴: **H 03 M 1/46**

(21) Numéro de dépôt: **82430046.1**

(22) Date de dépôt: **28.12.82**

(54) Convertisseur analogique/numérique.

(43) Date de publication de la demande:
**04.07.84 Bulletin 84/27**

(45) Mention de la délivrance du brevet:
**12.08.87 Bulletin 87/33**

(84) Etats contractants désignés:
**DE FR GB**

(56) Documents cité:
**US-A-2 762 038**

**IBM TECHNICAL DISCLOSURE BULLETIN, vol. 19, no. 5, octobre 1976, pages 1707-1708, New York, USA D.ESTEBAN et al.: "Analog-to-digital converter for generating two's complement code digital value"**

(73) Titulaire: **International Business Machines Corporation, Old Orchard Road, Armonk, N.Y. 10504 (US)**

(84) Etats contractants désignés: **DE GB**

(73) Titulaire: **Compagnie IBM FRANCE, 5 Place Vendôme, F-75000 Paris 1er (FR)**

(84) Etats contractants désignés: **FR**

(72) Inventeur: **Pilost, Daniel, 229, CR4 de l'Adret, F-06610 La Gaude (FR)**

(74) Mandataire: **Tubiana, Max, Compagnie IBM France Département de Propriété Industrielle, F-06610 La Gaude (FR)**

## Description

La présente invention traite de conversion d'un signal électrique, d'une représentation analogique en une représentation numérique et plus précisément en une représentation par une valeur numérique arrondie.

Les récepteurs de modems (modulateur/démodulateur) comportent des microprocesseurs traitant de manière numérique le signal reçu pour en déduire, après traitement, des données numériques destinées au terminal récepteur. Le signal se présentant à l'entrée du récepteur du modem sous forme analogique, doit être converti en numérique avant d'être soumis aux microprocesseurs. Cette conversion se fait par l'insertion d'un convertisseur analogique/numérique (ADC) entre l'entrée du récepteur et celle de la partie du microprocesseur de signal chargée des opérations de traitement numérique du signal reçu.

Lorsque le traitement numérique se fait sur des mots de N-bits, le convertisseur ADC est, en général conçu pour fournir des mots de $(N+1)$ bits qui sont ensuite arrondis à N-bits. L'opération, dite d'arrondi, est en général opérée par le processeur de signal. Pour ce faire, la valeur numérique $\pm 1/2$ est ajoutée à chaque mot de $(N+1)$ bits fourni par le convertisseur ADC. Le résultat de cette opération est ensuite tronqué à N-bits.

Toutes ces opérations doivent naturellement être effectuées dans un laps de temps d'autant plus court que le modem travaille à vitesse élevée. Il faut en effet échantillonner le signal analogique reçu à une fréquence d'autant plus grande que la vitesse du modem est élevée. Il faut ensuite effectuer et terminer la conversion en numérique de chaque échantillon avant l'arrivée de l'échantillon suivant. Or l'opération d'arrondi à l'aide du microprocesseur de traitement du signal, autrement dit en dehors du convertisseur ADC proprement dit comporte plusieurs étapes successives. Tout d'abord, il y a l'envoi par le convertisseur ADC, au microprocesseur, d'une demande d'interruption. Pour un modem haute vitesse, il n'est pas rare que compte tenu de la charge de travail du microprocesseur pour les opérations de traitement du signal proprement dites, une demande d'interruption ne puisse être satisfaite moins de 2 microsecondes ($\mu$s) après avoir été formulée. Après cela, il pourra rester au microprocesseur, moins de 20 $\mu$s pour traiter la demande d'interruption, ou en d'autres termes effectuer les opérations dites d'arrondi lesquelles opérations comportent: addition de $\pm 1/2$ à la valeur numérique à $(N+1)$ bits de l'échantillon de signal fourni par le convertisseur ADS; test de dépassement de capacité; puis coupure à N bits du résultat de l'addition.

En conséquence, l'utilisation d'un convertisseur analogique/numérique effectuant lui-même les opérations d'arrondi libérerait le microprocesseur de certaines opérations. Celui-ci aurait environ 20 $\mu$s de plus à consacrer au traitement de chaque échantillon de signal proprement dit.

On a déjà décrit dans le brevet US 2 762 038 un convertisseur analogique/numérique prenant lui-même en charge l'opération d'arrondi. Ce convertisseur utilise un comparateur dont l'une des entrées reçoit le signal analogique à convertir en numérique, tandis que l'autre entrée est reliée à la sortie du comparateur à travers un réseau de résistances pondérées. La conversion se fait en plusieurs étapes par approximations successives. Pour arrondir le résultat, la valeur de l'une des résistances du réseau est modifiée de manière à ajouter une valeur correspondant à la moitié de la tension correspondant au bit de poids le plus faible et d'ignorer tout bit devant se trouver au delà de la virgule.

La présente invention a pour objet un convertisseur analogique numérique fournissant des valeurs numériques arrondies dans un système fonctionnant en code dit complément à deux.

D'autres objets, caractéristiques et avantages de la présente invention ressortiront mieux de l'exposé, qui suit, fait en référence aux dessins annexés à ce texte, qui représentent un mode de réalisation préféré de celle-ci.

Brève Description des Figures

La Figure 1 est un schéma de principe de moyens classiques mis en jeu pour réaliser la fonction de conversion analogique/numérique arrondie.

La figure 2 est un schéma de principe de l'invention.

La figure 3 est un schéma du processus dichotomique de codage de l'invention.

La figure 4 représente un mode de réalisation du codeur de l'invention.

La figure 5 est un diagramme de fonctionnement de l'invention.

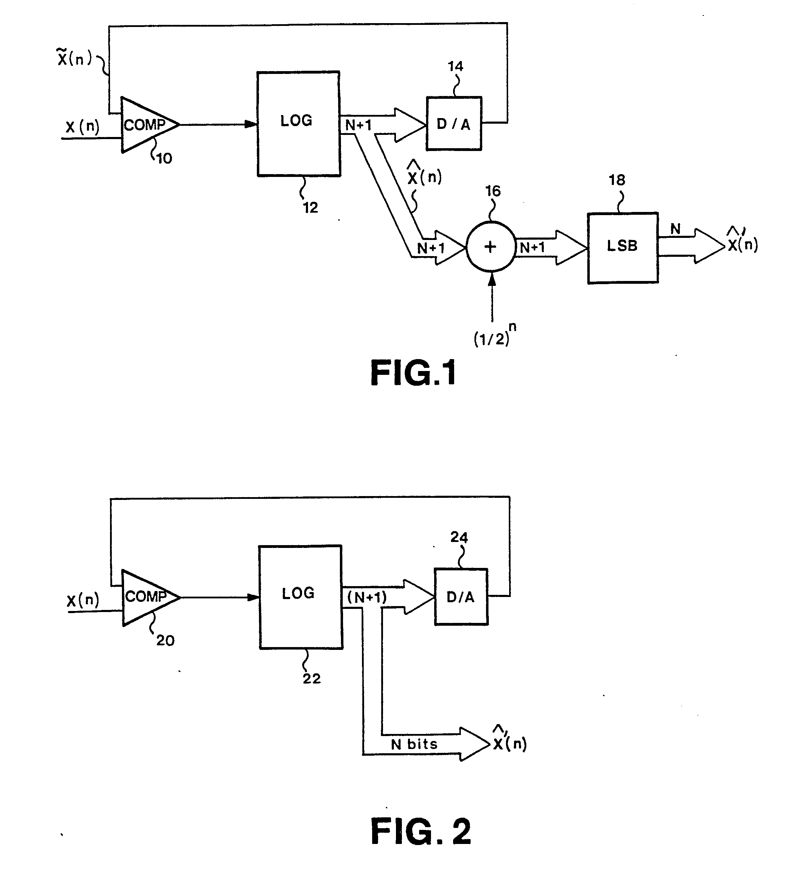

On a représenté sur la figure 1 un schéma de principe résumant les opérations conventionnelles conduisant à la conversion d'un signal analogique en valeurs numériques arrondies. L'échantillon $X_{(n)}$ (n indiquant le rang de l'échantillon dans le flot d'échantillons reçus) du signal à convertir en numérique est appliqué à un comparateur 10. La sortie du comparateur 10 commande un dispositif logique 12. Le dispositif logique 12 fournit $(N+1)$ bits représentants une valeur numérique approchée de l'échantillon $X_{(n)}$. Cette valeur approchée est reconvertie en analogique en 14 avant d'être ré-introduite dans le comparateur 10. L'ensemble comportant les éléments 10, 12 et 14 tend, par approximations successives, à réduire l'écart entre les deux entrées du comparateur 10, donc à traduire $X_{(n)}$ en une valeur numérique $X_{(n)}$, aussi précise que possible et comportant $(N+1)$ bits. Cette valeur $X_{(n)}$ se voit ensuite ajouter en 16 un terme dont la valeur numérique est égale à $(1/2)^N$. Le resultat de cette addition est ensuite soumis au dispositif 18 qui supprime le bit le moins significatif (LSB), et donc délivre une valeur numérique arrondie, $X'_{(n)}$ comportant N bits.

On remarquera que le dispositif que l'on vient de décrire comporte quelques inconvénients. A savoir notamment que l'itération destinée à fournir le terme $X_{(n)}$ à $(N+1)$ bits comporte $(N+1)$ étapes.

En outre, l'exécution des opérations d'arrondi exige soit des circuits supplémentaires, soit de la puissance de traitement supplémentaire au sein d'un microprocesseur.

On propose ici un convertisseur supprimant ces inconvénients, par recherche directe du résultat arrondi.

2

On va tout d'abord supposer que l'on cherche à exprimer le résultat par une progression géométrique de base 1/2 et comportant $(N+1)$ termes. On peut donc écrire:

$$X_{(n)} \approx \tfrac{V_M}{2}\,[k_0 + k_1(1/2) + k_2(1/2)^2 + \dots + k_{(N-1)}(1/2)^{N-1} + k_N(1/2)^N] \quad (1)$$

où $k_i = 0$ ou 1 pour $i = 0, 1, \dots, N$
et $V_M$ représente la valeur analogique maximum de l'échantillon à mesurer.

La série $k_0, k_1, \dots, k_N$ représente $(N+1)$ bits de l'échantillon codé $X_{(n)}$ aux erreurs de codage près.

Si l'on veut arrondir le résultat à $(1/2)^N$ près, par excès, on peut considérer que cela revient à ajouter dés le début de l'operation, $(V_M/2)(1/2)^N$ à la valeur analogique $X_{(n)}$ à mesurer. D'où un $X'_{(n)}{}' = X_n + V_M/2 \,(1/2)^N$.

On peut alors appliquer au terme $X'_{(n)}$ la méthode dichotomique conduisant, par approximations successives, à la détermination des coefficients $k_i$, de l'expression (1). On obtiendra donc:

$$X'_{(n)} \approx \tfrac{V_M}{2}\,[k_0' + k_1'(1/2) + \dots + k'_{(N-1)}(1/2)^{N-1}] \quad (2)$$

Lés termes $k_i'$ pour $i = 0$ à $(N-1)$ représentent les N bits recherchés.

Le tableau I représente une table de valeurs numériques exprimées en code complément à deux à 5 bits où l'on considérera que le plus petit bit a un poïd 1/2.

**TABLEAU I**

|            | Signe(-8) | 4 | 2 | 1 | 1/2 |
|------------|-----------|---|---|---|-----|
| $+V_M$     | 0 | 1 | 1 | 1 | 1 |
|            | 0 | 1 | 1 | 1 | 0 |
|            | 0 | 1 | 1 | 0 | 1 |
|            | 0 | 1 | 1 | 0 | 0 |
|            | 0 | 1 | 0 | 1 | 1 |
|            | 0 | 1 | 0 | 1 | 0 |
|            | 0 | 1 | 0 | 0 | 1 |
|            | 0 | 1 | 0 | 0 | 1 |
|            | 0 | 0 | 1 | 1 | 1 |
|            | 0 | 0 | 1 | 1 | 0 |
|            | 0 | 1 | 0 | 1 | 1 |
|            | 0 | 0 | 1 | 0 | 0 |
|            | 0 | 0 | 0 | 1 | 1 |
|            | 0 | 0 | 0 | 1 | 0 |
|            | 0 | 0 | 0 | 0 | 1 |
| 0          | 0 | 0 | 0 | 0 | 0 |
| $\varepsilon$ | 1 | 1 | 1 | 1 | 1 |
|            | 1 | 1 | 1 | 1 | 0 |
|            | 1 | 1 | 1 | 0 | 1 |
|            | 1 | 1 | 1 | 0 | 0 |
|            | 1 | 1 | 0 | 1 | 1 |
|            | 1 | 1 | 0 | 1 | 0 |
|            | 1 | 1 | 0 | 0 | 1 |
|            | 1 | 1 | 0 | 0 | 0 |
|            | 1 | 0 | 1 | 1 | 1 |
|            | 1 | 0 | 1 | 1 | 0 |
|            | 1 | 0 | 1 | 0 | 1 |
|            | 1 | 0 | 1 | 0 | 0 |
|            | 1 | 0 | 0 | 1 | 1 |
|            | 1 | 0 | 0 | 1 | 0 |
|            | 1 | 0 | 0 | 0 | 1 |
|            | 1 | 0 | 0 | 0 | 0 |
| $-V_M$     |   |   |   |   |   |

On constate grâce à cette table qu'il n'est pas nécessaire de prévoir des moyens supplémentaires pour ajouter en fait la valeur $(V_M/2)(1/2)^N$ à l'échantillon d'entrée. Il suffit en effet de conserver $(N+1)$ bits à l'entrée du convertisseur numérique analogique 14. Une fois le processus dichotomique terminé, on ne conservera que les N bits les plus significatifs (MSB) du résultat obtenu. D'où le schéma de principe de la figure 2. L'échantillon $X_{(n)}$ est envoyé à l'entrée d'un comparateur 20. La sortie de ce comparateur commande un dispositif logique LOG 22 travaillant sur $(N+1)$ bits. Les $(N+1)$ bits fournis par le dispositif logique 22 sont envoyés sur un convertisseur numérique analogique (D/A) 24 lui-même opérant sur $(N+1)$ bits et alimentant la seconde entrée du comparateur. Une fois le processus dichotomique terminé (N étapes suffisent), on ne conservera que les N bits les plus significatifs pour exprimer le terme arrondi recherché $X'_{(n)}$.

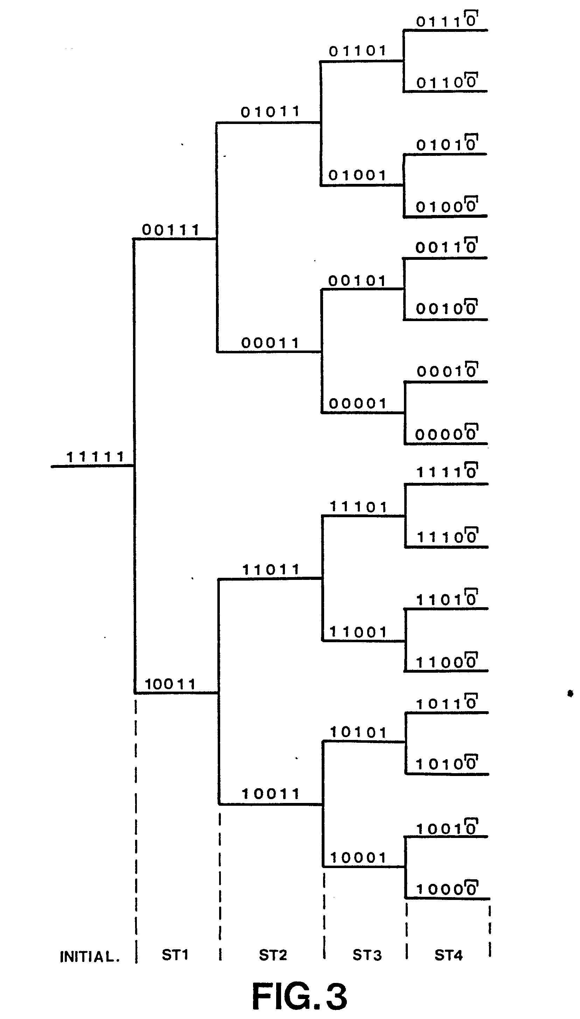

La figure 3 constitue une représentation schématique du processus dichotomique mis en jeu dans le dispositif logique 22.

Au démarrage du traitement d'un échantillon $X_{(n)}$ le dispositif de la figure 2 est initialisé en forçant les $(N+1)$ bits sortant du dispositif logique 22 à la valeur "1". Cette valeur est convertie en analogique par le convertisseur 24 et renvoyée à l'entrée du comparateur 20. Selon que le résultat de la comparaison en 20 est positif ou négatif, le bit le plus significatif est forcé à 0 ou à 1 comme dans la méthode de conversion classique. Mais, tout en réalisant cette opération, le dispositif logique 22 force à zéro le bit à droite du bit le plus significatif. La comparaison en 20 reprend avec cette nouvelle valeur de $X_{(n)}$ à $(N+1)$ bits. Le résultat de la comparaison sert à définir de manière conditionnelle le bit qui a été forcé à zéro, tandis que le bit immédiatement à sa droite est forcé à zéro, et ainsi de suite. On constate alors qu'en quatre étapes de rebouclage dans le comparateur 20 on a déterminé la valeur numérique arrondie à N bits de l'échantillon codé $X_{(n)}$. En résumé dans le procédé pour coder en code complément à deux à N bits avec arrondi à $(1/2)^N$ un échantillon $X_{(n)}$, on commence par forcer tous les bits d'un mot à $(N+1)$ bits à 1. Au cours d'une première étape d'un processus itératif, on compare ensuite une représentation analogique de ce mot à $(N+1)$ bits, à l'échantillon $X_{(n)}$ de manière à déterminer conditionnellement la valeur binaire à attribuer au bit le plus significatif (bit le plus à gauche) du mot à $(N+1)$ bits. On force à zéro de manière inconditionnelle le bit situé immédiatement à droite du bit déterminé conditionnellement. On obtient ainsi un nouveau mot à $(N+1)$ bits sur lequel on recommence le processus itératif (deuxième étape), laquelle étape commence par une comparaison du nouveau mot à $(N+1)$ bits avec $X_{(n)}$. Le résultat de cette comparaison sert à définir conditionnellement la valeur binaire à donner au bit précédemment forcé à zéro, tandis que l'on force à zéro le bit immédiatement à sa droite. Et ainsi de suite durant N étapes. Le résultat final arrondi recherché, $X'_{(n)}$, est obtenu en conservant, après la $N^{ième}$ étape, les N bits les plus significatifs du mot à $(N+1)$ bits ainsi déterminé.

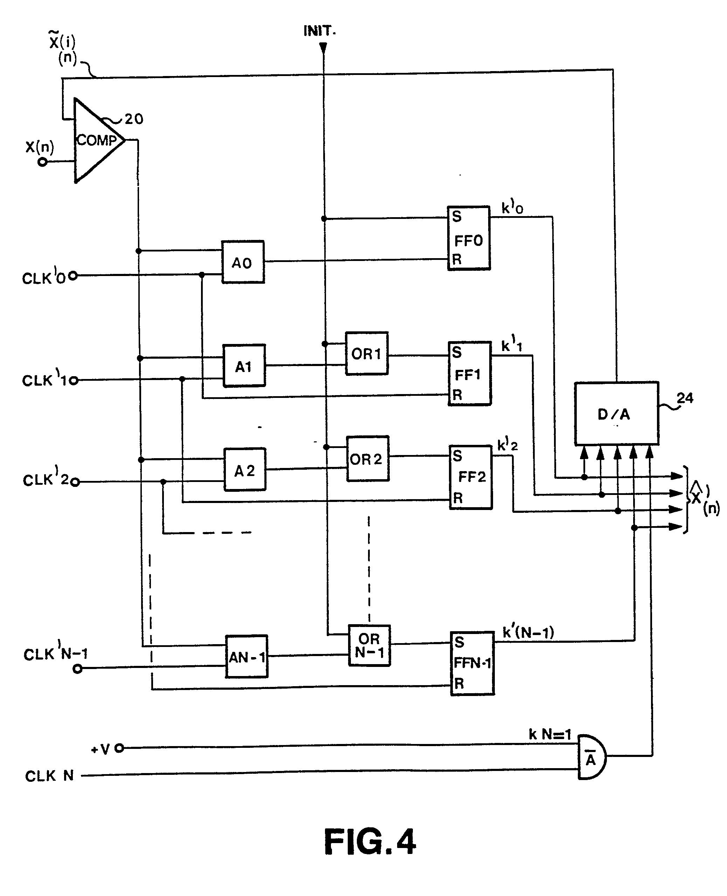

On a représenté sur la figure 4 un mode de réalisation du codeur ADC de l'invention montrant de façon détaillée le fonctionnement du dispositif logique 22. La sortie du comparateur 20 est connectée à l'une des entrées de N circuits ET logiques $A_0$, $A_1$, ..., $A_{N-1}$. Les secondes entrées des circuits ET, $A_0$ à $A_{N-1}$ dites entrées d'horloge et désignées par $CLK'_0$, $CLK'_1$, ..., $CLK'_{N-1}$ sont balayées de haut en bas par une impulsion d'horloge. La sortie de la bascule $A_0$ est connectée à l'entrée R dite de "restauration" ou de remise à zéro d'une bascule bistable $FF_0$ dite bascule de signe. L'entrée dite d'enclenchement "S" (ou SET) de la bascule $FF_0$ est connectée à une ligne d'initialisation INIT. Cette même ligne d'initialisation est aussi connectée à l'une des entrées d'un ensemble de circuits OU logiques, OR1, OR2, ..., $OR_{N-1}$. La seconde entrée de chacun de ces circuits OU est reliée à la sortie de l'un des circuits ET, $A_1$ à $A_{N-1}$. La sortie de chacun des circuits OU $OR_1$ à $OR_{N-1}$ est reliée à l'entrée (S) d'une bascule bistable en position de bits $FF_1$, $FF_2$, ..., $FF_{N-1}$. Les entrées de restauration des bascules $FF_1$ à $FF_{N-1}$ sont respectivement reliées aux entrées $CLK'_1$ à $K'_{N-1}$. Enfin, une ligne ininterrompue est portée à un potentiel $+V$ de manière à fournir un bit en permanence égal à 1 (bit kN, du mot $X_{(n)}$). Les sorties logiques normales des bascules $FF_0$ à $FF_{N-1}$ ainsi que la ligne $k_N=1$ qui est maintenue en permanence au niveau logique 1 sont reliées à l'entrée du convertisseur 24 dont la sortie est reliée à l'une des deux entrées du comparateur 20. L'ensemble de bascules ($FF_0$, $FF_1$, ..., $FF_{N-1}$) constitue le registre de sortie (ADC REG) du convertisseur analogique numérique de l'invention. Ce registre est destiné à contenir les N bits significatifs recherchés en fin de conversion, lesdits N bits comprenant notamment le bit dit de signe dans la bascule $FF_0$. Durant le processus de conversion par approximations successives, les N bits les plus significatifs de chaque valeur approchée à $(N+1)$ bits seront stockés dans le registre de sortie.

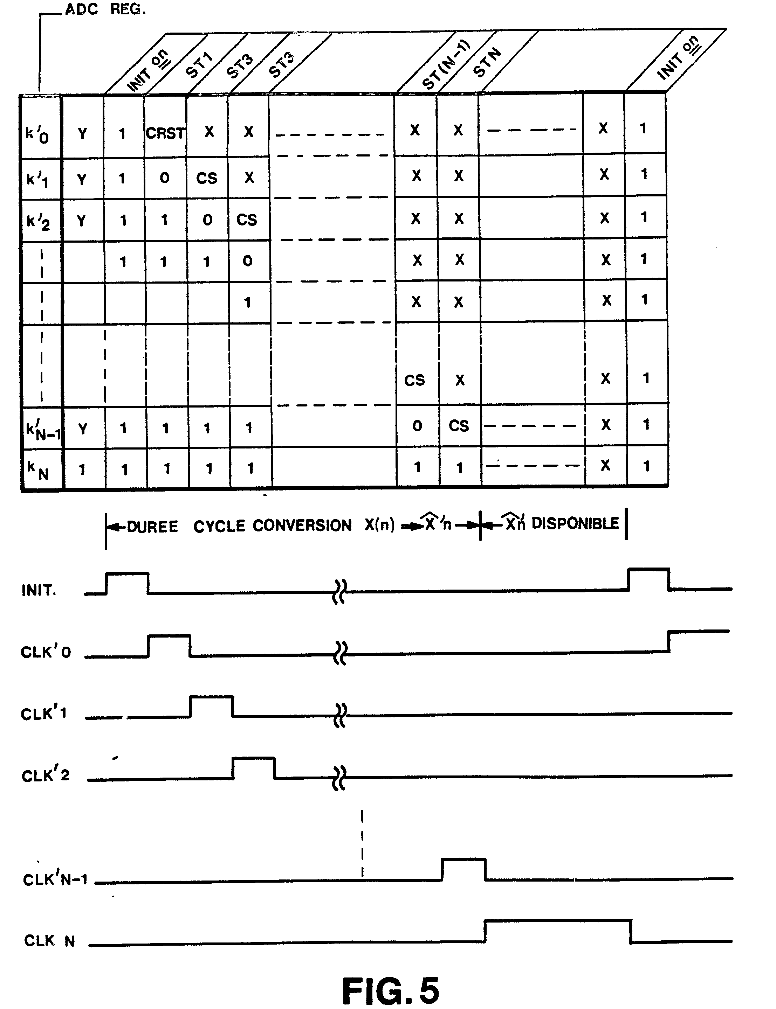

On a représenté sur la figure 5 un diagramme de fonctionnement montrant le déroulement des opérations de conversion dans le temps. La première colonne (colonne la plus à gauche) représente les différents étages du registre de sortie (ADC REG.) et de l'étage $k_N$ n'appartenant pas au registre de sortie du convertisseur. On suppose au départ tous les étages du registre de sortie dans un état indéterminé (Y). L'opération de conversion d'un échantillon $X_{(n)}$ commence lorsque se présente l'impulsion d'initialisation INIT qui force un bit 1 dans chacun des étages du registre ADC REG. L'entrée du convertisseur numérique analogique 24 reçoit donc un mot $X_{(n)}^{(1)}$ à $(N+1)$ bits tous égaux à 1. La valeur analogique reconstituée de ce mot, $\tilde{X}_{(n)}^{(1)}$, est appliquée à l'entrée du comparateur 20. Dès que l'impulsion d'horloge $CL.K'_0$ est appliquée à l'entrée de la porte ET $A_0$, la première étape ($ST_1$) d'un cycle de conversion du convertisseur ADC commence. Cette impulsion restaure inconditionnellement la bascule $FF_1$, autrement dit force $k_1$ à zéro. En outre selon que l'écart entre $\tilde{X}_{(n)}^{(1)}$ et $X_{(n)}$ sera positif ou négatif, la sortie du comparateur 20 sera portée à 1 ou à zéro. Si la sortie du comparateur est à 1, la bascule $FF_0$ est restaurée, ce qui correspond à une restauration conditionnelle (CRST).

L'entrée du convertisseur numérique/analogique 24 reçoit alors un mot à $(N+1)$ bits, $X_{(n)}^{(2)}$) représentant une première approximation à $(N+1)$ bits de la valeur codée de $X_{(n)}$. La valeur analogique $\tilde{X}_{(n)}^{(2)}$ correspondante est appliquée à l'entrée du comparateur 20. Dès que l'impulsion d'horloge $CL.K'_1$ est appliquée

4

à l'entrée de la porte $A_2$, la deuxième étape ($ST_2$) du cycle de conversion est entamée. La bascule $FF_2$ est restaurée ($k'_2 = 0$). Le résultat de la comparaison $\bar{X}_{(n)}^{(2)}$, $X_{(n)}$ effectué dans le comparateur 20 est appliquée à l'entrée "S" (entrée dite SET) de la bascule $FF_1$. Cette bascule est donc activée conditionnellement, ce qui est schématisé par CS sur la figure 5. Le contenu de la bascule $FF_0$ n'est pas modifié ce qui a été symbolisé par un X sur la figure 5. Le processus décrit ci-dessus se poursuit de proche en proche grâce au balayage opéré par l'impulsion d'horloge appliquée successivement aux entrées des portes $A_0$, $A_1$, ... $A_{N-1}$.

A la fin d'un cycle de conversion, la valeur de l'expression numérique arrondie recherchée de l'échantillon $X_{(n)}$, valeur arrondie désignée par $X'_{(n)}$ est disponible dans le registre ADC REG. Le registre de sortie contient alors un bit dit de signe dans $FF_0$ et les (N-1) autres bits significatifs dans les bascules $FF_1$ à $FF_{N-1}$. La fin du cycle de conversion est signalée par l'apparition d'un niveau logique égal à zéro à la sortie d'un circuit $\bar{A}$ effectuant la combinaison logique $\bar{ET}$ entre $k_N$ et l'impulsion d'horloge $CLK_N$.

## Revendications

1. Convertisseur analogique numérique destiné à convertir par une méthode dichotomique à approximations successives chaque échantillon d'un signal analogique en une valeur numérique exprimée en code binaire dit en complément à deux arrondie à N bits, ledit convertisseur comprenant:

un comparateur (20) à deux entrées dont l'une reçoit l'échantillon de signal à convertir en numérique;

un dispositif logique (22) relié audit comparateur et délivrant (N + 1) bits;

un convertisseur numérique analogique (24) relié audit dispositif logique et convertissant ledit mot à (N + 1) bits en une valeur analogique appliquée à la seconde entrée dudit convertisseur;

des moyens pour prélever en fin de conversion, les N bits les plus significatifs obtenus à la sortie dudit dispositif logique;

ledit convertisseur étant caractérisé en ce qu'il comprend en outre des moyens (22) pour forcer initialement chacun desdits (N + 1) bits délivrés par le dispositif logique à la valeur binaire 1 et pour démarrer un processus de conversion par approximations successives, processus basé sur une méthode dichotomique à N étapes au cours de chacune desquelles un bit est forcé inconditionnellement à zéro, tandis que le bit adjacent audit bit forcé à zéro et de poids immédiatement supérieur est déterminé conditionnellement en fonction de la valeur obtenue à la sortie dudit comparateur.

2. Convertisseur analogique-numérique selon la revendication 1, caractérisé en ce que ledit dispositif logique comprend: N circuits logiques ET (AO à AN-1) à deux entrées dont l'une est reliée à la sortie du comparateur;

un registre de sortie constitué de N bascules bistables (FFO à FFN-1) dont l'une des entrées est reliée à la sortie d'un des circuits logiques ET et dont la sortie est reliée à l'entrée du convertisseur numérigue-analogique (24);

des moyens pour forcer l'une des entrées du convertisseur numérique-analogique à la valeur binaire 1;

des moyens d'initialisation pour forcer initialement les N bascules bistables à l'état un; et,

des moyens d'horloge (CLK'O à CLK'N-1) permettant de balayer successivement les secondes entrées desdits N circuits logiques ET tout en restaurant successivement et de manière inconditionnelle les bascules bistables.

3. Convertisseur analogique-numérique selon la revendication 1 caractérisé en ce que ledit dispositif logique comprend:

N circuits logiques ET (AO à AN-1) à deux entrées dont l'une est reliée à la sortie du comparateur, les autres entrées étant respectivement reliées à des entrées dites d'horloge;

un registre de sortie constitué de N bascules bistables (FFO à FFN-1) destinées à contenir le bit de signe et les (N-1) autres bits significatifs du résultat recherché à la $N^{ième}$ étape du processus de conversion, chacune desdites bascules ayant une entrée dite d'enclenchement (S) et une entrée dite de restauration (R);

des moyens dits d'intitialisation (INIT) reliés aux eentrées (S) desdites bascules, lesdites liaisons se faisant directement pour la bascule de signe et à travers un circuit OU logique (ORI à ORN-1) pour les (N-1) autres bascules;

des moyens pour relier l'entrée (R) de la bascule de signe à la sortie de l'un desdits circuits logiques ET;

des moyens pour relier la sortie de chacun des autres circuits logiques ET à l'entrée d'un desdits circuits logiques OU;

des moyens pour relier chacune des entrées dites (R) des bascules de registre de sortie à l'exception de la bascule de signe à l'une des entrées dites d'horloge,

des moyens pour relier les sorties normales des bascules de registre de sortie à l'entrée du convertisseur numérique-analogique, chacune desdites bascules fournissant un bit du mot à convertir dans ledit convertisseur numérique-analogique; et,

des moyens pour fournir le bit de poids le plus faible du mot soumis à l'entrée du convertisseur numérique-analogique, et pour forcer ce bit de poids le plus faible à la valeur binaire un.

**Patentansprüche**

1. Analog-Digital-Umsetzer, dazu bestimmt, mittels einer dichotomischen Methode mit aufeinanderfolgenden Annäherungen jeden Abschnitt eines Analogsignals in einen digitalen Wert umzuwandeln, der in Binärcode, als Komplement zu zwei auf N Bits abgerundeten Werten angesehen, ausgedrückt wird, wobei jeder dieser Umsetzer aufweist:

einen Komparator (20) mit 2 Eingängen, von denen einer den in einen Digitalwert umzusetzenden Signalabschnitt empfängt;

einen logischen Baustein (22), der mit dem genannten Komparator verbunden ist und (N + 1) Bits erstellt;

einen Digital-Analog-Umsetzer (24), der mit dem genannten logischen Baustein verbunden ist und das genannte Wort von (N + 1) Bits in einen Analogwert umwandelt, um diesen in den zweiten Eingang des genannten Umsetzers eingeben zu können;,

Mittel, um an Ende dieser Umsetzung die am Ausgang des genannten logischen Bausteins anstehenden N höchstwertigen Bits abzugreifen;

wobei der genannte Umsetzer dadurch gekennzeichnet ist, dass er zusätzlich dazu noch Mittel (22) aufweist, um anfänglich jedes der vom logischen Baustein erstellten (N + 1) Bits forciert auf den Binärwert 1 zu setzen und um durch aufeinanderfolgende Annäherungen ein Umsetzverfahren einzuleiten, das auf einer dichotomischen Methode mit N Schritten beruht, und dass bei jedem dieser Schritte ein Bit unbedingt ausgenullt wird während das dem ausgenullten Bit benachbarte Bit mit dem nächsthöheren Wert bedingt im Verhältnis zu dem am Ausgang des genannten Komparators erhaltenen Wert determiniert wird.

2. Analog-Digital-Umsetzer nach Anspruch 1, dadurch gekennzeichnet, dass der genannte logische Baustein aufweist:

N logische UND-Schaltungen (AO bis AN-1) mit je zwei Eingängen, von denen einer mit dem Ausgang des Komparators verbunden ist;

ein Ausgaberegister mit N bistabilen Kippgliedern (FFO bis FFN-1), bei denen einer der Eingänge mit dem Ausgang einer der logischen UND-Schaltungen verbunden ist während der Ausgang an den Eingang des Digital-Analog-Umsetzers (24) gelegt ist;

Mittel, um einen der Eingänge des Digital-Analog-Umsetzers auf den Binärwert 1 zu setzen;

Initialisierungsmittel, um am Anfang die N bistabilen Kippglieder auf den Status 1 zu bringen; u

Taktgebermittel (CLK'O bis CLK'N-1), um mit deren Hilfe die zweiten Eingänge der genannten logischen UND-Schaltungen nacheinander abzutasten und dabei die bistabilen Kippglieder nacheinander und unbedingt in die Grundstellung zu bringen.

3. Analog-Digital-Umsetzer nach Anspruch 1, dadurch gekennzeichnet, dass der genannte logische Baustein weiter aufweist:

N logische UND-Schaltungen (AO bis AN-1) mit zwei Eingängen, von denen einer mit dem Ausgang des Komparators verbunden ist während die anderen jeweils mit den sogenannten Taktgebereingängen verbunden sind;

ein aus N bistabilen Kippgliedern (FFO bis FFN-1) bestehendes Ausgangsregister, wobei diese Kippglieder das Vorzeichenbit und die (N-1) anderen Bits, die dem während des N. Umsetzverfahrenschrittes erhaltenen Ergebnis entsprechen, enthalten müssen und jedes dieser Kippglieder einen sogenannten Auslöseeingang (S) und sowie einen anderen sogenannten Wiederherstellkngseingang (R) aufweist; mit den Eingängen (S) der genannten Kippglieder verbundene Initialisierungsmittel (INIT), deren Verbindungen für das Vorzeichen-Kippglied direkt sind, während sie für die anderen Kippglieder über eine logische ODER-Schaltung (OR1 bis ORN-1) gehen;

Mittel, um den Eingang (R) des Vorzeichen-Kippgliedes mit dem Ausgang einer der genannten logischen UND-Schaltungen zu verbinden;

Mittel, um den Ausgang jeder der anderen logischen UND-Schaltungen mit dem Eingang einer der genannten logischen ODER-Schaltungen zu verbinden;

Mittel, um jeden der sogenannten (R)-Eingänge der Kippglieder des Ausgaberegisters mit Ausnahme des Vorzeichen-Kippgliedes mit einem der sogenannten Taktgeber-Eingänge zu verbinden;

Mittel, um die normalen Ausgänge der Ausgaberegister-Kippglieder mit dem Eingang des Digital-Analog-Umsetzers zu verbinden, wobei jedes der genannten Kippglieder ein Bit des im genannten Digital-Analog-Umsetzers umzuformenden Wortes erstellt, und

Mittel, um das niedrigstwertige Bit des Wortes am Eingang des Digital-Analog-Umsetzers zu erstellen, und um dieses niedrigstwertige Bit forciert auf den Binärwert 1 zu setzen.

**Claims**

An analog-to-digital converter for converting by means of a dichotomic method involving successive approximations every sample of an analog signal into an N-bit rounded-off digital value encoded in the so-called two's complement binary code, said converter including:

a comparator (20) one of the two inputs of which receives the signal sample to be converted to a digital value;

a logic device (22) connected to said comparator and supplying (N + 1) bits;

a digital-to-analog converter (24) connected to said logic device for converting said (N + 1)-bit word into an analog value applied to the second input of said converter;

means for retaining, upon completion of said conversion, the N most significant bits obtained at the output of said logic device;

said converter being characterized in that it further includes means (22) for initially forcing each of said (N + 1) bits supplied by said logic device to a binary "1" value and for initiating a conversion process involving successive approximations that is based upon an N-step dichotomic method during each of which steps a bit is unconditionally forced to zero, while the immediately higher-order bit adjacent to said bit forced to zero is conditionally determined as a function of the value obtained at the output of said comparator.

2. An analog-to-digital converter according to claim 1, characterized in that said logic device includes:

N two-input AND logic circuits (AO to AN-1), one of the inputs of each of which is connected to the output of the comparator;

an output register comprised of N flip-flop circuits (FFO to FFN-1) one of the inputs of each of which is connected to the output of one of the AND logic circuits and the output of each of which is connected to the input of said digital-to-analog converter (24);

means for forcing one of the inputs of the digital-to-analog converter to a binary "1" value;

initialization means for initially forcing said N flip-flop circuits to the "1" state; and

clock means (CLK'O to CLK'N-1) adapted to successively scan the second inputs of said N AND logic circuits while successively and unconditionally resetting said flip-flop circuits.

3. An analog-to-digital converter according to claim 1, characterized in that said logic device includes:

N two-input AND logic circuits (AO to AN-1), one of the inputs of each of which is connected to the output of the comparator, the other inputs being respectively connected to said clock inputs;

an output register comprised of N flip-flop circuits (FFO to FFN-1) adapted to store the sign bit and the other (N-1) significant bits of the desired result at the Nth step of the conversion process, each of said flip-flop circuits having a set (S) input and a reset (R) input;

initialization means (INIT) connected to the (S) inputs of said flip-flop circuits, said connections being made directly in the case of the sign flip-flop and through an OR logic circuit (ORI to ORN-1) in the case of the other (N-1) flip-flops;.

means for connecting the (R) input of the sign flip-flop to the output of one of said AND logic circuits;

means for connecting the output of each of the other AND logic circuits to the input of one of said OR logic circuits;

means for connecting each of the (R) inputs of the flip-flop circuits of said output register, with the exception of the sign flip-flop, to one of said clock inputs;

means for connecting the true outputs of the flip-flop circuits of said output register to the input of the digital-to-analog converter, with each of said flip-flop circuits supplying one bit of the word to be converted therein; and

means for supplying the least significant bit applied to the input of said digital-to-analog converter and for forcing said least significant bit to a binary "1" value.

7

**FIG.1**

**FIG. 2**

1

# FIG.3

**FIG.4**

ADC REG.

| | INIT on | | ST1 | ST3 | ST3 | | ST(N-1) | STN | | | INIT on |
|---|---|---|---|---|---|---|---|---|---|---|---|
| $k'_0$ | Y | 1 | CRST | X | X | – – – – | X | X | – – – – | X | 1 |
| $k'_1$ | Y | 1 | 0 | CS | X | | X | X | | X | 1 |
| $k'_2$ | Y | 1 | 1 | 0 | CS | | X | X | | X | 1 |
| ⋮ | | 1 | 1 | 1 | 0 | | X | X | | X | 1 |
| ⋮ | | | | | 1 | | X | X | | X | 1 |
| ⋮ | | | | | | | CS | X | | X | 1 |
| $k'_{N-1}$ | Y | 1 | 1 | 1 | 1 | | 0 | CS | – – – – | X | 1 |
| $k_N$ | 1 | 1 | 1 | 1 | 1 | | 1 | 1 | – – – – | X | 1 |

|←DUREE  CYCLE CONVERSION  $X(n) \rightarrow \widehat{X}'_n \rightarrow$|←$\widehat{X}''_n$ DISPONIBLE|

INIT.

CLK'0

CLK'1

CLK'2

CLK'N-1

CLK N

# FIG.5